# EUROPÄISCHE PATENTSCHRIFT

(11) **EP 1 516 358 B1**
(45) Veröffentlichungstag und Bekanntmachung des Hinweises auf die Patenterteilung: **12.12.2007**
(21) Anmeldenummer: 03761411.2
(22) Anmeldetag: 04.06.2003
(51) Int. Cl.: H01L 21/00

(54) **VORRICHTUNG ZUM ABHOLEN VON IC"S VON EINEM WAFER**
DEVICE FOR PICKING IC'S FROM A WAFER
DISPOSITIF POUR PRELEVER DES CI D'UNE TRANCHE DE SEMI-CONDUCTEUR

(30) Priorität: 26.06.2002 DE 10228555
(43) Veröffentlichungstag der Anmeldung: 23.03.2005
(73) Patentinhaber: SIEMENS AKTIENGESELLSCHAFT, 80506 München (DE)
(72) Erfinder: JUNGE, Volker, 80636 München (DE)
(86) Internationale Anmeldenummer: PCT/DE2003/001870
(87) Internationale Veröffentlichungsnummer: WO 2004/003978

(56) Entgegenhaltungen:
- EP-A- 0 660 657
- US-A- 5 840 594
- PATENT ABSTRACTS OF JAPAN vol. 1998, no. 06, 30. April 1998 (1998-04-30) & JP 10 041695 A (MATSUSHITA ELECTRIC IND CO LTD), 13. Februar 1998 (1998-02-13)

## Beschreibung

Vorrichtung zum Abholen von IC's von einem Wafer Die Erfindung bezieht sich auf eine Vorrichtung zum gleichzeitigen Abholen mehrerer IC's von einem Wafer, wobei die IC's an einem Träger des Wafers lösbar fixiert sind und von dort mittels zumindest einer Greifeinrichtung mit mehreren Greifelementen für die einzelnen IC's entnehmbar sind.

Ein derartige Vorrichtung ist z.B. durch die US 6283693 B bekannt geworden. Danach ist ein Saugkopf mit einer Vielzahl von Saugkanälen versehen, deren Teilungsabstand auf den Abstand der IC's auf dem Wafer abstimmt ist. Unterhalb des Wafers sind deckungsgleich Abdrücknadeln angeordnet, die die IC's weitgehend von ihrer Trägerfolie lösen. Die Vorrichtung eignet sich nur zum Abholen von IC's gleicher Abmessungen. Da diese den Rasterabstand auf dem Wafer bestimmen und nicht standardisiert sind, muss für jede IC-Größe eine eigene Vorrichtung geschaffen werden.

Ferner ist es üblich, eine Universalvorrichtung für unterschiedlich große IC's mit nur einem frei positionierbaren Greifer auszustatten, der mittels seiner PositionierEinrichtung von IC zu IC verfahren werden kann. Da das Lösen der Klebeverbindung mit einem relativ großen Zeitaufwand verbunden ist, bleibt hierbei die Stückleistung niedrig.

Der Erfindung liegt die Aufgabe zugrunde, mit einer Vorrichtung unterschiedliche IC-Größen entnehmen zu können.

Diese Aufgabe wird durch die Erfindung gemäß Anspruch 1 gelöst. Durch die Ausbildung der Greifelemente als separate einzelne Greifer und durch die Verstelleinrichtung ist es möglich, die Greiferabstände genau auf die Rasterabstände der IC's abzustimmen. Es versteht sich, dass bei sehr engen Abständen die Greifer entsprechend nadelartig schlank werden müssen. Die Vorrichtung muss jeweils nur dann umgerüstet werden, wenn Wafer mit einer anderen IC-Größe verarbeitet werden müssen. Während des Abholens bleiben die Greiferabstände unverändert. Durch die Aufnahme einer Vielzahl von IC's wird die Stückleistung beim Vereinzeln entsprechend erhöht.

Durch die Erfindung ist es möglich, die Stückleistung soweit zu erhöhen, dass das Abholen der IC's auf die Leistung einer weiterverarbeitenden Vorrichtung abgestimmt werden kann. Beispielsweise ist es in Bestückautomaten für Leiterplatten bekannt, Mehrfachbestückköpfe zu verwenden, die eine Vielzahl von Bauelementen gleichzeitig aufnehmen können. Durch die Erfindung ist es möglich, die vielfach bereitgestellten IC's in kurzer Zeit an den Bestückkopf weitergeben zu können.

Vorteilhafte Weiterbildungen der Erfindung sind in den Ansprüchen 2 bis 16 gekennzeichnet:

Durch die Vorrichtung nach Anspruch 2 ist es möglich, den stationären Greifer als Referenzgreifer festzulegen, dessen Position die relative Lage der Greifeinrichtung zum Wafer definiert.

Die schwenkbare Lagerung nach Anspruch 3 ist mit geringem konstruktivem Aufwand zu verwirklichen.

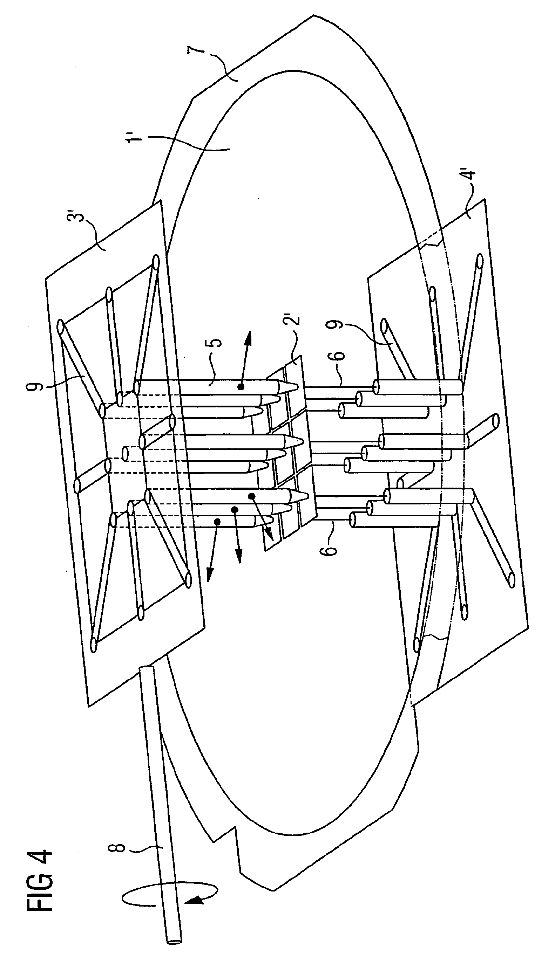

Die linearen Führungsbahnen nach Figur 4 ermöglichen eine Verstellung der Greifer ohne Winkelkorrektur.

Durch die Weiterbildung nach Anspruch 5 kann die Greifeinrichtung toleranzarm auf den mittleren Greifer eingestellt werden.

Die Greifeinrichtung nach den Ansprüchen 6 und 7 ermöglicht eine kompakte Anordnung der Greifer. Durch die sternförmige Anordnung der Greifer und Führungsbahnen bleibt beim Versellen der Abstände das Seitenverhältnis unverändert, was insbesondere bei quadratischen IC's eine mühelose Einstellung auf unterschiedliche Größen ermöglicht.

Durch die Einzelantriebe nach Anspruch 8 ist es möglich, die Greiferpositionen an unterschiedliche Seitenverhältnisse der IC's anzupassen.

Durch die Weiterbildungen nach den Ansprüchen 9 und 10 kann der Aufwand für den Antrieb und ein zugehöriges Mess-System erheblich verringert werden.

Die Schieber nach Anspruch 11 ermöglichen eine einfache Umsetzung der Antriebsbewegung auf die Greifer an allen Außenseiten.

Die z. B. um 180° schwenkbare Greifeinrichtung nach Anspruch 12 macht es möglich, die Flipchips in einer geeigneten Lage z. B. an einem Bestückkopf zu übergeben. Die Flipchips sind mit ihrer isolierten Rückseite am Wafer gehalten, so dass die Kontakte nach oben weisen. Die Greifer saugen die Flipchips mit deren Kontaktseite an und wenden diese um 180°, so dass sie nun vom Bestückkopf an der Rückseite gegriffen werden können, um sie mit ihrer Kontaktseite auf ein Substrat aufsetzen zu können.

Durch die Weiterbildung nach Anspruch 13 ist es möglich, gleichzeitig vom Wafer abzuholen und die zuvor abgeholten und nach oben gedrehten IC's an den Bestückkopf abzugeben, wodurch sich die Zykluszeit halbiert und die Abholleistung erheblich erhöht werden kann.

Durch die Weiterbildungen nach Anspruch 13 und 14 ist es möglich, die zu beiden Seiten der Achse abstehenden Greifer mit einem gemeinsamen Antrieb zu verstellen.

Durch die Weiterbildung nach Anspruch 15 ist es möglich, für die Verstellung der Nadeln die gleichen Verstellmittel zu verwenden, wie für die Greifer. An die Stelle der mechanischen Abdrückeinrichtung kann z.B. auch Heizung treten, die die Haftung zwischen den IC's und der Trägerfolie verringert.

Durch die zeitliche Staffelung nach Anspruch 16 können die IC' leichter aus ihrem Verbund herausgelöst werden.

Im Folgenden wird die Erfindung anhand von in der Zeichnung schematisch dargestellten Ausführungsbeispielen näher erläutert. Es zeigen:
- Figur 1: perspektivisch eine Vorrichtung zum Abholen von einem Wafer mit großen IC's mittels dreier in einer Reihe angeordneten Greifern,
- Figur 2: die Vorrichtung nach Figur 1 mit kleinen IC's,
- Figur 3: perspektivisch eine andere Vorrichtung mit in mehreren Reihen angeordneten Greifern mit großen IC's,
- Figur 4: die Vorrichtung nach Figur 3 mit kleinen IC's,
- Figur 5: einen Teil der Vorrichtung nach Figur 4 in einer verdrehten Lage,
- Figur 6: einen abgewandelten Greifer einer anderen Abholvorrichtung für IC's,
- Figur 7: einen vergößerten Ausschnitt aus der Vorrichtung nach Figur 1,
- Figur 8: eine Draufsicht auf eine Verstelleinrichtung für die Greifer nach Figur 3,
- Figur 9: die Verstelleinrichtung nach Figur 8 in einer geänderten Einstellung,
- Figur 10: eine Draufsicht auf eine andere Verstelleinrichtung für die Greifer nach Figur 3,
- Figur 11: die Verstelleinrichtung nach Figur 10 in einer geänderten Einstellung.

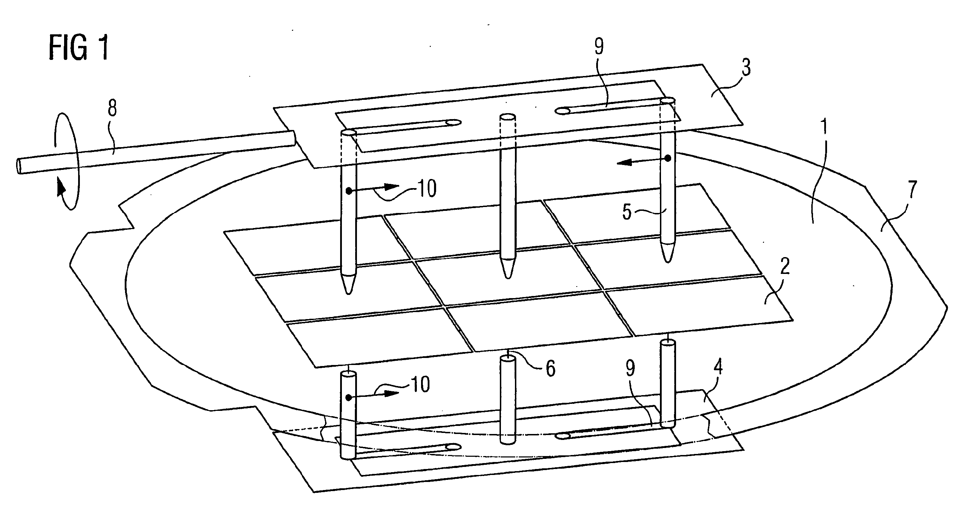

Figur 1 zeigt einen Wafer 1 mit relativ großen IC's 2. Der Wafer 1 ist zwischen einer Greifeinrichtung 3 und einer Abdrückeinrichtung 4 gehalten. Die Greifeinrichtung 3 ist mit drei nadelartigen Greifern 5 versehen, die auf das Zentrum dreier in einer Reihe aufeinanderfolgender IC's 2 gerichtet sind. Die Abdrückeinrichtung 4 weist zu den Greifern 5 diesen entgegenragende und zu diesen kongruente Abdrückelemente 6 auf, ebenfalls nadelartig ausgebildet sind.

Saugöffnungen der Sauggreifer 5 sind an den dem Wafer zugewandten Spitzen ausgebildet sind. Diese befinden sich mit geringem Abstand über den Oberseiten der IC's, die mit ihrer Unterseite an einem folienartigen Träger angeklebt sind. Durch Anheben der Abdrückelemente 6 werden die zugehörigen IC's 2 angehoben und lösen sich dabei größtenteils vom Träger 7. Durch die Saugkraft der Greifer 5 können sie nun festgehalten und vollständig vom Träger 7 abgelöst werden. Die Greifeinrichtung 3 ist um eine zum Wafer 1 parallele Achse 8 verdrehbar. Dadurch können die angesaugten IC's 2 zum Beispiel um 180° nach oben gedreht und von dort von einem anderen Handhabungswerkzeug, z. B. einem Bestückkopf zum Bestücken von Leiterplatten aufgenommen werden.

Die Greifeinrichtung 3 wie auch die Abdrückeinrichtung 4 sind mit linearen Führungsbahnen 9 versehen, die sich in der Reihenrichtung der IC's erstrecken. Die Greifer 5 sind in den Führungsbahnen mittels Antrieben 10 verschiebbar, so dass der Abstand feinstufig auf unterschiedliche Distanzen einstellbar ist.

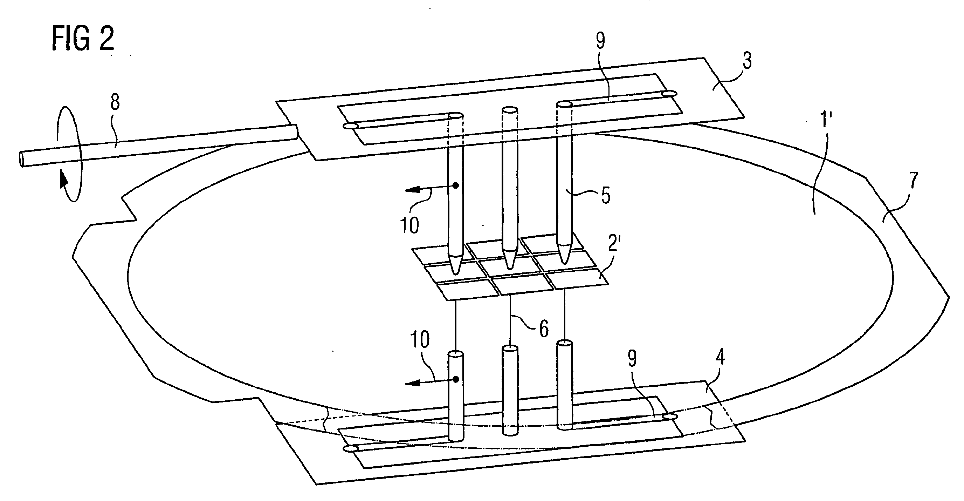

In Figur 1 ist der größtmögliche, in Figur 2 der kleinstmögliche Abstand dargestellt, wie er zum Abholen von entsprechend kleinen IC's 2' benötigt wird. Durch den feinstufig wirkenden Antrieb 10 können aber auch beliebige andere Abstände zwischen den Greifern 5 eingestellt werden, die den Rasterabständen zwischen IC's anderer Größe entsprechen.

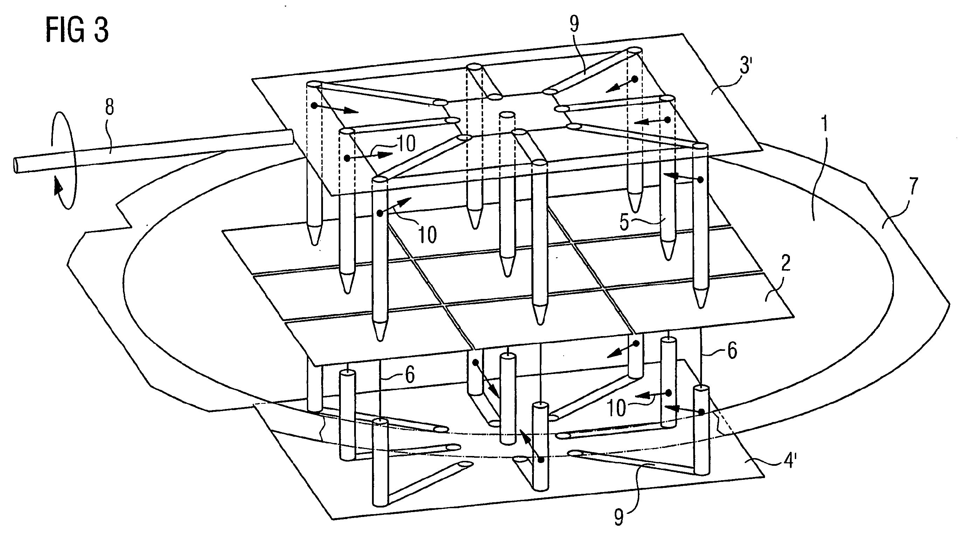

Die Vorrichtung nach Figur 3 ist mit einer abgewandelten Greifeinrichtung 3' und einer abgewandelten Abdrückeinrichtung 4' versehen. Diese weisen jeweils neun in drei Reihen angeordnete Greifer 5 bzw. Abdrückelemente 6 auf. Der Abstand ist auf die IC's 2 des Wafers 1 nach Figur 1 eingestellt. Der zentrale Greifer 5 ist in der Greifeinrichtung 3' stationär angeordnet, die äußeren Greifer 5 sind in den sternförmig auf den mittleren stationären Greifer 5 gerichteten Führungsbahnen 9 der Greifeinrichtung 3' parallel zum Wafer 1 geführt. Die Abdrücknadeln 6 sind in gleicher Weise in zu den Führungsbahnen 9 der Greifeinrichtung 3' kongruenten Führungsbahnen 9 der Abdrückeinrichtung 4' geführt. Die beweglichen Greifer 5 bzw. Abdrückelemente 6 sind mittels der Antriebe 10 in den Führungsbahnen stufenlos verschiebbar und auf andere Rasterabstände von anderen IC-Typen einstellbar, wobei analog Figur 2 die Vorrichtung nach Figur 4 die kleinstmöglichen Abstände für die kleinstmöglichen IC's 2' darstellt.

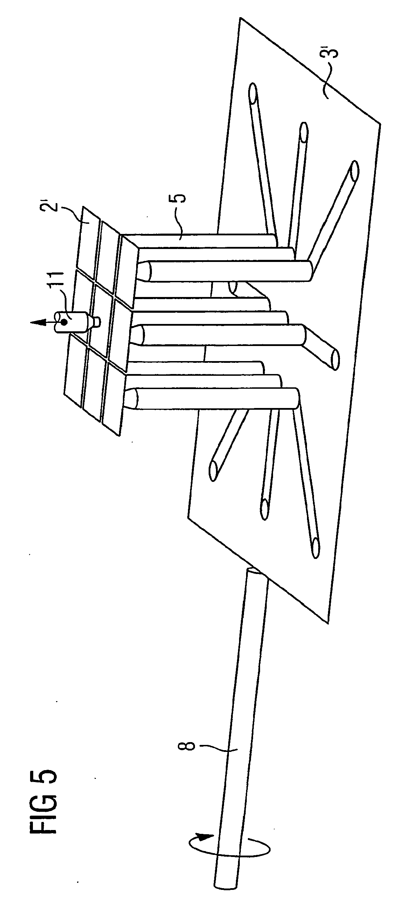

Figur 5 zeigt die Greifeinrichtung 3' nach Figur 4 nach dem Ansaugen der IC's 2' und nach einer Drehung von 180° um die Achse 8. Die als Flipchips ausgebildeten IC's 2' sind dadurch gegenüber ihrer Lage im Wafer 1' in eine gewendete Lage gebracht worden, in der ihre Anschlüsse auf der den Greifern 5 zugewandten Unterseite liegen. Die IC's 2' können nun der Reihe nach von Sauggreifern 11 eines Bestückkopfs abgeholt und auf ein Substrat aufgesetzt werden.

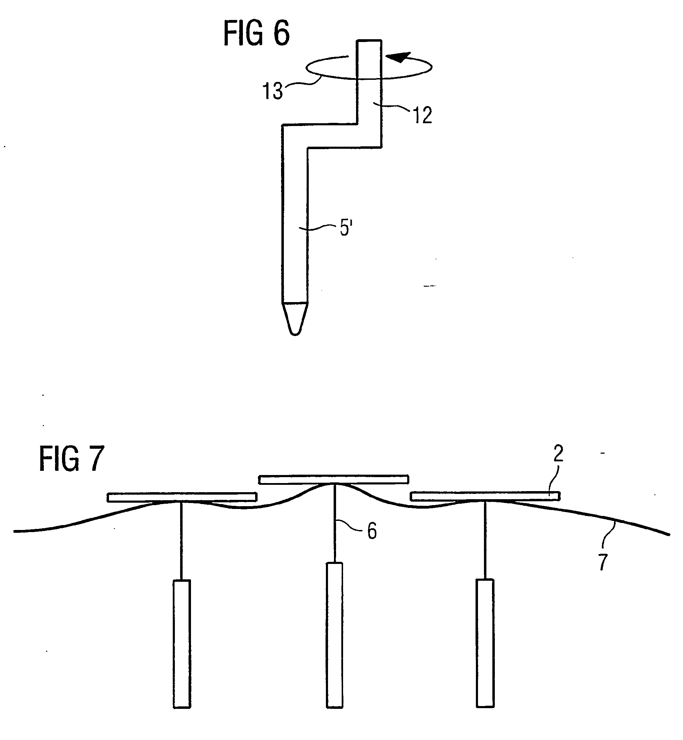

Ein anderer Greifer 5' nach Figur 6 weist in der Art einer Kurbel einen geknickten Verlauf auf, und ist um eine zum Wafer senkrechte Schwenkachse 12 mittels eines Schwenkantriebs 13 verstellbar. Auf diese Weise ist es möglich, die Abstände zwischen den Greifern 5' der Greifeinrichtung gegenläufig zu verändern und unterschiedlichen Chip-Größen anzupassen, wobei eine entsprechende Winkelkorrektur der Greifeinrichtung vorgenommen werden muss.

Figur 7 zeigt schematisch den Anteil der Abdrückelemente 6 mittels unterschiedlicher Hubantriebe voreilend gegen den Träger 7 gedrückt werden kann, wodurch sich die entsprechenden IC's 2 besser aus dem Wafer herauslösen lassen. Durch nachfolgendes Anheben der anderen Andrückelemente 6 lassen sich die restlichen IC's 2 entnehmen.

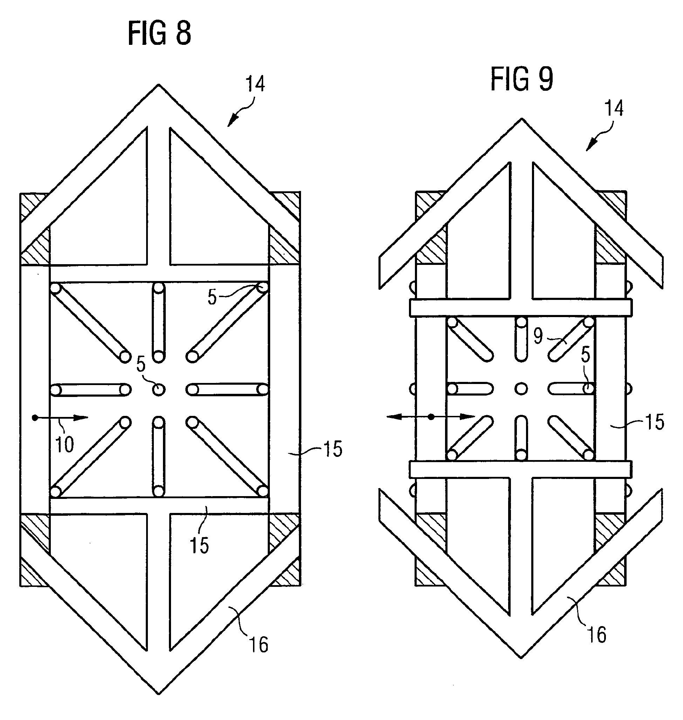

Die Figuren 8 und 9 zeigen in einer schematisierten Draufsicht eine Verstelleinrichtung 14 der Greifeinrichtung 3'. Dabei werden die Greifer 5 bzw. in gleicher Weise die Abdrückelemente der Abdrückeinrichtung mittels von außen angesetzter, sich überlappender Schieber 15 verstellt, die durch den Antrieb 10 sowie durch eine kulissenartige Umlenkeinrichtung 16 gleichzeitig synchron derart verschoben werden, dass sie stets auf den zentralen stationären Greifer 5 zentriert sind, wie dies bei einer Mittelstellung nach Figur 9 erkennbar ist.

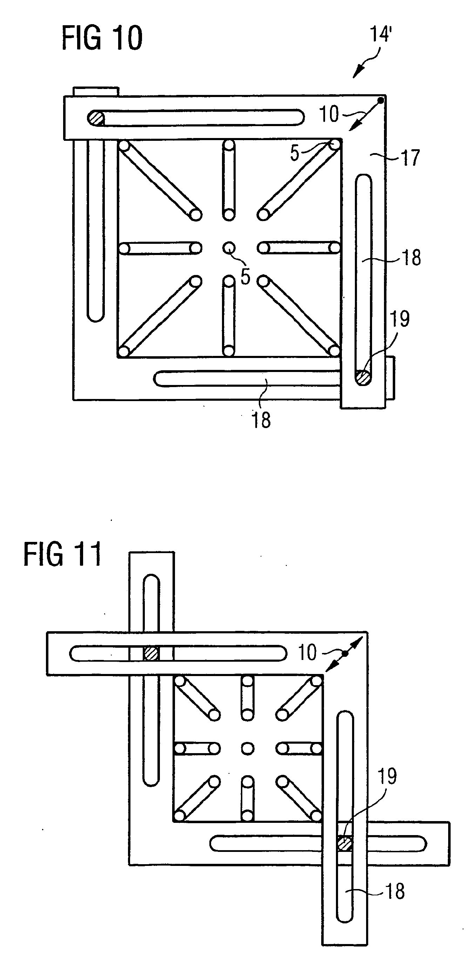

Die Figuren 10 und 11 zeigen eine abgewandelte Verstelleinrichtung 14', bei der sich zwei Winkelschieber 17 an ihren freien Enden einander scherenartig überlappen und über Führungsschlitze und Führungsstifte 19 miteinander kinematisch derart gekoppelt sind, dass sie durch den diagonal angesetzten Antrieb 10 eine veränderbare Stellfläche für die äußeren Greifer 5 umschließen, die sich z. B. federnd an die Innenseiten der Winkelschieber 17 anlegen.

## Patentansprüche

1. Vorrichtung zum gleichzeitigen Abholen mehrerer IC's (2, 2') von einem Wafer (1, 1'),
wobei die IC's (2, 2') an einem Träger (7) des Wafers (1, 1') lösbar fixiert sind und von dort mittels zumindest einer Greifeinrichtung (3, 3') mit mehreren Greifelementen für die einzelnen IC's (2, 2') entnehmbar sind,
**dadurch gekennzeichnet, dass** die Greifelemente als separate Greifer (5) ausgebildet sind und
dass in der Greifeinrichtung (3, 3') die Abstände zwischen den Greifern (5) mittels einer Verstelleinrichtung (14, 14') feinstufig parallel zur Ebene des Wafers (1, 1') veränderbar sind.

2. Vorrichtung nach Anspruch 1,
**dadurch gekennzeichnet, dass** einer der Greifer (5) in der Greifeinrichtung (3, 3') stationär angeordnet und die anderen Greifer (5) verstellbar angeordnet sind.

3. Vorrichtung nach Anspruch 1 oder 2,
**dadurch gekennzeichnet, dass** die verstellbaren Greifer (5) in der Greifeinrichtung (3, 3') um eine zum Wafer (1, 1') senkrechte Schwenkachse (12) schwenkbar gelagert sind.

4. Vorrichtung nach Anspruch 1 oder 2,
**dadurch gekennzeichnet, dass** die verstellbaren Greifer (5) in linearen Führungsbahnen (9) der Greifeinrichtung (3, 3') geführt sind.

5. Vorrichtung nach Anspruch 2, 3 oder 4,
**dadurch gekennzeichnet, dass** die Greifeinrichtung (3) eine ungerade Anzahl, vorzugsweise drei der in einer Reihe angeordneten Greifer (5) aufweist und
dass der mittlere Greifer (5) stationär und die beiden äußeren Greifer (5) verstellbar sind.

6. Vorrichtung nach Anspruch 2, 3 oder 4,
**dadurch gekennzeichnet, dass** die Greifer (5) in der Greifeinrichtung (3') in einer mehrreihigen Matrix angeordnet sind.

7. Vorrichtung nach Anspruch 6,
**dadurch gekennzeichnet, dass** die Greifeinrichtung (3') neun der Greifer (5) aufweist, von denen acht äußere in einem Rechteck, insbesondere einem Quadrat verteilt angeordnet sind,
dass der stationäre Greifer (5) im Zentrum des Rechtecks angeordnet ist und
dass die äußeren Greifer (5) in den sternförmig zum mittleren Greifer (5) weisenden linearen Führungsbahnen (9) geführt sind.

8. Vorrichtung nach einem der vorhergehenden Ansprüche,
**dadurch gekennzeichnet, dass** die Verstelleinrichtung Einzelantriebe für die einzeln verstellbaren Greifer (5) aufweist.

9. Vorrichtung nach Anspruch 8,
**dadurch gekennzeichnet, dass** mehrere der verstellbaren Greifer (5) durch einen gemeinsamen Antrieb (10) verstellbar sind.

10. Vorrichtung nach Anspruch 9
**dadurch gekennzeichnet, dass** die äußeren Greifer (5) durch den einzigen Antrieb (10) verstellbar sind und
dass die Stellbewegung des Antriebs (10) über kinematische Umlenkeinrichtungen (14, 14') auf die Greifer (5) übertragbar ist.

11. Vorrichtung nach Anspruch 10,
**dadurch gekennzeichnet, dass** die Umlenkeinrichtungen (14, 14') an den einander abgewandten Seiten der Greifer (5) angesetzte, auf den stationären Greifer (5) zentrierte Schieber (15) aufweisen.

12. Vorrichtung nach einem der vorhergehenden Ansprüche,
**dadurch gekennzeichnet, dass** die Greifeinrichtung (3, 3') um eine zur Waferebene parallele Achse (8) in eine Abhollage für die als Flip-Chips ausgebildeten IC's (2, 2') schwenkbar ist.

13. Vorrichtung nach Anspruch 12,
**dadurch gekennzeichnet, dass** zu beiden Seiten der Achse je eine Gruppe der deckungsgleichen Greifer (5) angeordnet ist.

14. Vorrichtung nach Anspruch 13,
**dadurch gekennzeichnet, dass** die Greifer beider Gruppen durch den gemeinsamen Antrieb verstellbar sind.

15. Vorrichtung nach einem der vorhergehenden Ansprüche,
**dadurch gekennzeichnet, dass** auf der den Greifern (5) gegenüberliegenden Seite des Wafers (1, 1') zu den Greifern (5) komplementäre, insbesondere als Nadeln ausgebildete Abdrückelemente (6) einer Abdrückeinrichtung (4, 4') vorgesehen sind, die mittels eigener Antriebe (10) entsprechend den Greiferpositionen verstellbar sind.

16. Vorrichtung nach Anspruch 15,
**dadurch gekennzeichnet, dass** die Nadeln in zeitlicher Staffelung auf den flexiblen Träger (7) aufsetzbar sind.

## Claims

1. Apparatus for simultaneously removing a number of ICs (2, 2') from a wafer (1, 1'),
wherein the ICs (2, 2') are detachably fixed on a mount (7) for the wafer (1, 1') from where they can be removed by means of at least one gripping device (3, 3') having a number of gripping elements for the individual ICs (2, 2'),
**characterized in that** the gripping elements are in the form of separate grippers (5), and **in that** the distances between the grippers (5) in the gripping device (3, 3') can be varied in fine steps parallel to the plane of the wafer (1, 1') by means of a movement device (14, 14').

2. Apparatus according to Claim 1,
**characterized in that** one of the grippers (5) is arranged such that it is stationary in the gripping device (3, 3'), and the other grippers (5) are arranged such that they can move.

3. Apparatus according to Claim 1 or 2,
**characterized in that** the moveable grippers (5) are mounted in the gripping device (3, 3') such that they can pivot about a pivoting axis (12) at right angles to the wafer (1, 1').

4. Apparatus according to Claim 1 or 2,
**characterized in that** the moveable grippers (5) are guided in linear guide tracks (9) in the gripping device (3, 3').

5. Apparatus according to Claim 2, 3 or 4,
**characterized in that** the gripping device (3) has an odd number of grippers (5), preferably three, which are arranged in a row, and **in that** the central gripper (5) is stationary and the two outer grippers (5) can move.

6. Apparatus according to Claim 2, 3 or 4,
**characterized in that** the grippers (5) are arranged in a multi-row matrix in the gripping device (3').

7. Apparatus according to Claim 6,
**characterized in that** the gripping device (3') has nine of the grippers (5), eight of which are arranged distributed on the outside in a rectangle, in particular a square,
**in that** the stationary gripper (5) is arranged in the center of the rectangle, and
**in that** the outer grippers (5) are guided in linear guide tracks (9) which point in the form of a star with respect to the central gripper (5).

8. Apparatus according to one of the preceding claims,
**characterized in that** the movement device has individual drives for the individually moveable grippers (5).

9. Apparatus according to Claim 8,
**characterized in that** a number of the moveable grippers (5) can be moved by a joint drive (10).

10. Apparatus according to Claim 9,
**characterized in that** the outer grippers (5) can be moved by the single drive (10), and
**in that** the actuating movement of the drive (10) can be transmitted via kinematic deflection devices (14, 14') to the grippers (5).

11. Apparatus according to Claim 10,
**characterized in that** the deflection devices (14, 14') have slides (15) which are fitted to the mutually facing sides of the grippers (5) and are centered on the stationary gripper (5).

12. Apparatus according to one of the preceding claims,
**characterized in that** the gripping device (3, 3') can pivot about an axis (8) which is parallel to the wafer plane, to a removal position for the ICs (2, 2') which are in the form of flip chips.

13. Apparatus according to Claim 12,
**characterized in that** one group of coincident grippers (5) is arranged on each of the two sides of the axis.

14. Apparatus according to Claim 13,
**characterized in that** the grippers in the two groups can be moved by the joint drive.

15. Apparatus according to one of the preceding claims,
**characterized in that** pushing-off elements (6) which are complementary to the grippers (5) and in particular are in the form of needles, of a pushing-off device (4, 4') are provided on the side of the wafer (1, 1') opposite the grippers (5) and can be moved by means of their own drives (10) in a corresponding manner to the gripper positions.

16. Apparatus according to Claim 15,
**characterized in that** the needles can be placed on the flexible mount (7) with a time stagger.

## Revendications

1. Dispositif pour prélever simultanément plusieurs CI (2, 2') d'une tranche de semi-conducteur (1, 1'),
les CI (2, 2') étant fixés de manière amovible sur un porteur (7) de la tranche de semi-conducteur (1, 1') et pouvant en être prélevés au moyen d'au moins un dispositif de préhension (3, 3') comprenant plusieurs éléments de préhension pour chacun des CI (2, 2'),
**caractérisé en ce que** les éléments de préhension sont exécutés comme des preneurs séparés (5) et **en ce que** dans le dispositif de préhension (3, 3'), les écarts entre les preneurs (5) sont modifiables avec haute précision, parallèlement au plan de la tranche de semi-conducteur (1, 1'), au moyen d'un dispositif de réglage (14, 14').

2. Dispositif selon la revendication 1,
**caractérisé en ce que** l'un des preneurs (5) est disposé de manière stationnaire dans le dispositif de préhension (3, 3') et **en ce que** les autres preneurs (5) sont disposés de manière réglable.

3. Dispositif selon la revendication 1 ou 2,
**caractérisé en ce que** les preneurs (5) réglables sont logés dans le dispositif de préhension (3, 3') de manière pivotante autour d'un axe de pivotement (12) perpendiculaire à la tranche de semi-conducteur (1, 1').

4. Dispositif selon la revendication 1 ou 2,
**caractérisé en ce que** les preneurs (5) réglables sont guidés dans des voies de guidage linéaires (9) du dispositif de préhension (3, 3').

5. Dispositif selon la revendication 2, 3 ou 4,
**caractérisé en ce que** le dispositif de préhension (3) présente un nombre impair de preneurs (5), de préférence trois des preneurs disposés en une rangée, et **en ce que** le preneur central (5) est stationnaire et les deux preneurs extérieurs (5) sont réglables.

6. Dispositif selon la revendication 2, 3 ou 4,
**caractérisé en ce que** les preneurs (5) dans le dispositif de préhension (3') sont disposés dans une matrice à plusieurs rangées.

7. Dispositif selon la revendication 6,
**caractérisé en ce que** le dispositif de préhension (3') présente neuf des preneurs (5), dont huit extérieurs sont disposés en étant répartis dans un rectangle, notamment un carré,
**en ce que** le preneur stationnaire (5) est disposé au centre du rectangle et
**en ce que** les preneurs extérieurs (5) sont menés dans les voies de guidage (9) linéaires dirigées en forme d'étoile vers le preneur central (5).

8. Dispositif selon l'une quelconque des revendications précédentes,
**caractérisé en ce que** le dispositif de réglage présente des entraînements individuels pour chacun des preneurs réglables (5).

9. Dispositif selon la revendication 8,
**caractérisé en ce que** plusieurs des preneurs réglables (5) sont réglables au moyen d'un entraînement commun (10).

10. Dispositif selon la revendication 9,
**caractérisé en ce que** les preneurs extérieurs (5) sont réglables au moyen du seul entraînement (10) et
**en ce que** le mouvement de réglage de l'entraînement (10) est transmissible aux preneurs (5) par l'intermédiaire de dispositifs de renvoi cinématiques (14, 14').

11. Dispositif selon la revendication 10,
**caractérisé en ce que** les dispositifs de renvoi (14, 14') présentent des coulisseaux (15) adjacents aux côtés des preneurs (5) détournés les uns des autres et centrés sur le preneur stationnaire (5).

12. Dispositif selon l'une quelconque des revendications précédentes,
**caractérisé en ce que** le dispositif de préhension (3, 3') est pivotant autour d'un axe (8) parallèle au plan de la tranche de semi-conducteur, dans une position de prélèvement pour les CI (2, 2') exécutés comme flip-chips.

13. Dispositif selon la revendication 12,
**caractérisé en ce qu'**un groupe des preneurs coïncidents (5) est respectivement disposé des deux côtés de l'axe.

14. Dispositif selon la revendication 13,
**caractérisé en ce que** les preneurs des deux groupes sont réglables au moyen de l'entraînement commun.

15. Dispositif selon l'une quelconque des revendications précédentes,
**caractérisé en ce que** des éléments d'éjection (6) complémentaires d'un dispositif d'éjection (4, 4'), notamment des éléments d'éjection exécutés comme des aiguilles, sont prévus sur le côté, opposé aux preneurs (5), de la tranche de semi-conducteur (1, 1'), ces éléments d'éjection étant réglables selon les positions des preneurs au moyen de propres entraînements (10).

16. Dispositif selon la revendication 15,
**caractérisé en ce que** les aiguilles peuvent être posées sur le porteur flexible (7) par échelonnement temporel.
